Europäisches Patentamt

European Patent Office

Office européen des brevets

(19)

(11)  EP 0 797 294 B1

(12)  FASCICULE DE BREVET EUROPEEN

(45) Date de publication et mention
de la délivrance du brevet:
**06.02.2002  Bulletin 2002/06**

(51) Int Cl.⁷: **H03F 1/32**

(21) Numéro de dépôt: **97400614.0**

(22) Date de dépôt: **19.03.1997**

(54) **Procédé pour corriger des non-linéarités d'un amplificateur, et émetteur radio mettant en oeuvre un tel procédé**

Verfahren zur Korrektur von nichtlinearen Verzerrungen in einem Verstärker und ein solches Verfahren verwendenden Funksenders

Method for correcting non-linear distortion of an amplifier and radio transmitter using such method

(84) Etats contractants désignés:
**AT BE CH DE DK ES FI GB GR IE IT LI LU MC NL PT SE**

(30) Priorité:  **22.03.1996  FR 9603617**

(43) Date de publication de la demande:
**24.09.1997  Bulletin 1997/39**

(73) Titulaire: **MATRA NORTEL COMMUNICATIONS
29000 Quimper (FR)**

(72) Inventeurs:
• **Schnabl, Gottfried
   89073 Ulm (DE)**
• **Peltier, Jacques
   75014 Paris (FR)**

(74) Mandataire: **Loisel, Bertrand
   Cabinet Plasseraud, 84, rue d'Amsterdam
   75440 Paris Cédex 09 (FR)**

(56) Documents cités:
**EP-A- 0 632 624          EP-A- 0 658 975
GB-A- 2 239 770**

**Description**

La présente invention concerne un procédé pour corriger des non-linéarités d'un amplificateur de puissance radio.

L'invention trouve des applications dans des émetteurs radio, notamment de stations mobiles de radiocommunication.

Les systèmes numériques de radiocommunication mobile utilisent de plus en plus souvent des modulations radio à enveloppe non constante afin d'améliorer l'efficacité spectrale du système. Ces modulations à enveloppe non constante comprennent notamment les modulations par déplacement de phase en quadrature (QPSK, OQPSK ou $\pi$/4-QPSK), ou encore les modulations par déplacement d'amplitude et de phase en quadrature (modulations n-QAM).

Pour un débit d'informations donné, ces modulations ont l'avantage de requérir une largeur de bande fréquentielle plus faible que les modulations à enveloppe constante fréquemment utilisées telles que la modulation GMSK. La contrepartie de cet avantage est que les modulations à enveloppe non constante nécessitent une chaîne d'émission très linéaire afin d'éviter l'élargissement du spectre dû aux non-linéarités. Le point critique de cette chaîne est en général l'amplificateur de puissance de l'émetteur. Dans le cas d'une station mobile de radiocommunication, pour laquelle la consommation électrique doit être minimisée, l'utilisation d'un amplificateur linéaire fonctionnant en classe A n'est généralement pas acceptable du fait de son rendement trop faible. Une solution plus appropriée consiste à utiliser un amplificateur non-linéaire à fort rendement combiné avec une technique de linéarisation.

La technique de linéarisation par prédistorsion adaptative est une technique de linéarisation d'amplificateur utilisable à cette fin. Cette technique est décrite dans l'article "Adaptive Linearisation Using Predistorsion" de M. Faulkner et al (Proc. of the 40th IEEE Veh. Tech. Conf. 1990, pages 35-40), et dans le brevet américain 5 093 637. La technique de linéarisation par prédistorsion adaptative consiste à appliquer une table de prédistorsion au signal complexe en bande de base. Cette table est calculée numériquement en comparant le signal en bande de base et un signal démodulé obtenu à partir du signal radio amplifié. Ce calcul consiste à modifier la table de prédistorsion afin d'obtenir une table corrigeant les distorsions de la chaîne d'émission. Après une période d'adaptation initiale, la table de prédistorsion corrige les non-linéarités de l'amplificateur.

Les algorithmes de prédistorsion employés sont généralement basés sur l'hypothèse que la distorsion introduite par l'amplificateur de puissance dépend uniquement du module du signal complexe en bande de base et non de sa phase (distorsions AM-AM et AM-PM uniquement). En conséquence, on choisit des fonctions de prédistorsion qui dépendent seulement du module du signal. Néanmoins, certaines distorsions peuvent également être introduites par le modulateur servant à transposer le signal autour de la fréquence porteuse, ainsi que par le démodulateur produisant le signal démodulé utile dans les périodes d'adaptation. Le modulateur et le démodulateur peuvent présenter des défauts de balance et/ou de quadrature qui, outre les distorsions PM-AM et PM-PM qu'ils introduisent, risquent de faire converger l'algorithme d'adaptation vers une table de prédistorsion inadéquate. Le signal démodulé peut encore présenter un décalage de zéro par rapport au signal d'adaptation en bande de base. Un autre problème pouvant perturber la convergence de l'algorithme de prédistorsion est la présence de bruit dans le signal démodulé.

Un but de la présente invention est de proposer une technique efficace de linéarisation qui soit moins affectée par les problèmes ci-dessus.

L'invention propose ainsi un procédé pour corriger des non-linéarités d'un amplificateur recevant un signal radio et produisant un signal radio amplifié représentatif d'un signal numérique complexe d'entrée, dans lequel on mémorise une table de prédistorsion associant une valeur d'un signal numérique complexe prédistordu à chaque valeur du signal complexe d'entrée, et on module le signal complexe prédistordu pour obtenir le signal radio adressé à l'amplificateur. Dans une période d'adaptation, on démodule une fraction du signal radio amplifié pour obtenir un signal complexe démodulé qu'on compare au signal complexe d'entrée auquel est associé le signal complexe prédistordu modulé dans ladite période d'adaptation pour mettre à jour la table de prédistorsion. Selon l'invention. la table de prédistorsion est mise à jour sur la base de valeurs moyennes calculées à partir de blocs d'échantillons du signal complexe d'entrée et du signal complexe démodulé mémorisés dans la période d'adaptation.

Le fait de mettre à jour la table sur la base de valeurs moyennes calculées sur des blocs d'échantillons plutôt que sur la base d'échantillons individuels permet à l'algorithme d'être relativement peu sensible à des fluctuations non significatives que peut présenter le signal démodulé en raison de l'influence du bruit ou encore de défauts de balance et/ou de quadrature du modulateur ou du démodulateur.

Dans un mode de réalisation typique, le module du signal complexe d'entrée est quantifié pour l'adressage dans la table de prédistorsion, la table de prédistorsion associant une valeur de module et une valeur de déphasage du signal prédistordu à chaque valeur de quantification du module du signal complexe d'entrée. On peut alors prévoir, pour chaque valeur de quantification du module du signal complexe d'entrée, un calcul de la valeur moyenne de la différence de module entre le signal complexe démodulé et le signal complexe d'entrée, et de la valeur moyenne de la différence de phase entre le signal complexe démodulé et le signal complexe d'entrée, lesdites valeurs moyennes étant calculées pour les échantillons du signal complexe d'entrée du bloc mémorisé dans la période d'adaptation dont le module est quantifié par ladite valeur de quantification, et une mise à jour de la valeur de module et la valeur de déphasage du signal complexe prédistordu associées à ladite valeur de quantification sur la base desdites valeurs moyennes calculées.

De préférence, chaque bloc d'échantillons du signal complexe démodulé est mémorisé sous forme de composantes en phase et de composantes en quadrature, on estime la valeur moyenne des composantes en phase du bloc et la valeur moyenne des composantes en quadrature du bloc, et on produit un signal complexe démodulé corrigé pour la mise à jour de la table de prédistorsion en soustrayant respectivement des composantes en phase et en quadrature mémorisées de chaque échantillon du signal complexe démodulé les valeurs moyennes estimées desdites composantes en phase et en quadrature. Ceci permet d'évaluer et de corriger un décalage de zéro (offset) que peut présenter le signal démodulé.

L'invention permet également un ajustement précis du retard à appliquer au signal d'adaptation avant de le comparer au signal démodulé. Ce retard peut être estimé à partir d'une corrélation entre les modules du signal d'adaptation et du signal démodulé, calculée sur un ensemble d'échantillons des blocs mémorisés.

Avantageusement, le signal complexe d'entrée ou le signal complexe prédistordu possède une phase constante modulo $\pi$ dans la période d'adaptation.

Si un signal complexe a une partie réelle, ou composante en phase, de la forme $I=\rho\cos\varphi$ et une partie imaginaire, ou composante en quadrature, de la forme $Q=\rho\sin\varphi$, on entend par "phase" du signal complexe l'argument $\varphi$ du nombre complexe $I+jQ$. Lorsque cette phase est constante (modulo $\pi$) pour le signal numérique complexe d'entrée ou le signal numérique complexe prédistordu dans la période d'adaptation, l'algorithme d'adaptation de la table de prédistorsion est peu perturbé par les distorsions PM-AM et PM-PM pouvant résulter de défauts du modulateur ou du démodulateur. Il en résulte une meilleure performance du procédé de correction des non-linéarités grâce à une meilleure convergence de l'algorithme.

De préférence, le signal complexe d'entrée a un spectre plus étroit dans la période d'adaptation qu'en dehors de la période d'adaptation. Ceci limite les émissions indésirables en dehors de la bande passante allouée, dans les périodes d'adaptation pendant lesquelles l'algorithme d'adaptation des tables n'a pas encore convergé.

Un autre aspect de la présente invention concerne un émetteur radio comprenant : une source de signal numérique générant un signal numérique complexe d'entrée ; des moyens de prédistorsion produisant un signal numérique complexe prédistordu sur la base du signal complexe d'entrée et d'une table de prédistorsion ; des moyens de modulation produisant un signal radio à partir du signal complexe prédistordu ; un amplificateur de puissance pour amplifier le signal radio et l'appliquer à une antenne d'émission ; et des moyens de démodulation produisant un signal complexe démodulé à partir d'une fraction du signal radio amplifié. Les moyens de prédistorsion sont agencés pour mettre à jour la table de prédistorsion sur la base d'une comparaison entre le signal complexe démodulé produit par les moyens de démodulation dans au moins une période d'adaptation et le signal complexe d'entrée auquel est associé le signal complexe prédistordu produit dans ladite période d'adaptation par les moyens de prédistorsion. Les moyens de prédistorsion sont agencés pour mettre à jour la table de prédistorsion sur la base de valeurs moyennes calculées à partir de blocs d'échantillons du signal complexe d'entrée et du signal complexe démodulé mémorisés dans la période d'adaptation.

D'autres particularités et avantages de la présente invention apparaîtront dans la description ci-après d'un exemple de réalisation non limitatif, en référence aux dessins annexés, dans lesquels :

- la figure 1 est un schéma synoptique d'un émetteur radio adapté à la mise en oeuvre de la présente invention ;
- la figure 2 est un schéma synoptique d'une source de signal numérique de l'émetteur de la figure 1 ;
- la figure 3 est un graphique montrant l'effet des non-linéarités d'un amplificateur sur le spectre d'un signal radio ;
- la figure 4 est un schéma synoptique d'une unité de prédistorsion de l'émetteur de la figure 1 ;
- la figure 5 est un schéma de principe d'un modulateur radio en quadrature ;
- la figure 6 est un graphique montrant l'amélioration procurée par l'utilisation d'un signal d'adaptation à phase constante sur le spectre du signal linéarisé ;
- la figure 7 est un graphique montrant le spectre du signal émis pendant les phases d'adaptation lorsqu'on utilise un signal d'adaptation à bande étroite ;
- la figure 8 montre une variante de réalisation d'une unité de prédistorsion ; et
- la figure 9 est un schéma synoptique de moyens de mise à jour d'une table de prédistorsion.

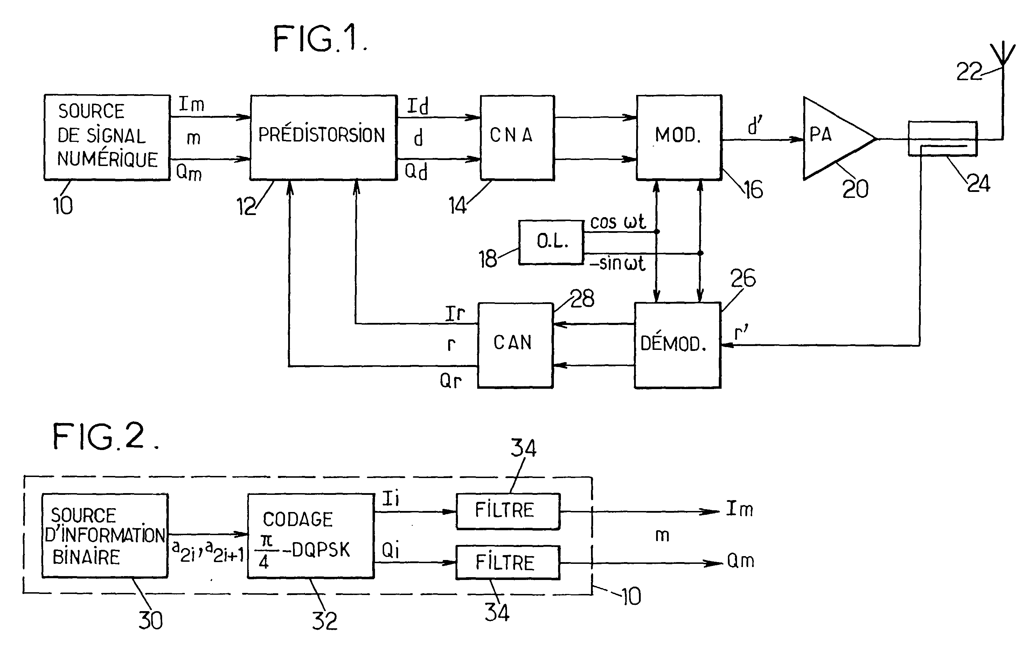

L'émetteur radio représenté sur la figure 1 fait par exemple partie d'une station mobile de radiocommunication numérique. La référence 10 désigne une source de signal numérique produisant un signal complexe d'entrée m sous forme d'une composante en phase $I_m$ et une composante en quadrature $Q_m$ à une fréquence d'échantillonnage $F_s$. Une unité de prédistorsion 12 applique une prédistorsion au signal d'entrée m pour produire un signal numérique complexe prédistordu d ayant une composante en phase $I_d$ et une composante en quadrature $Q_d$. Ce signal prédistordu est converti en analogique par un convertisseur numérique-analogique 14, puis fourni à un modulateur en quadrature 16. Sur la base du signal prédistordu et de deux ondes en quadrature cos$\omega$t et -sin$\omega$t fournies par un oscillateur local 18, le modulateur 16 délivre un signal radio d'. Si $\rho_d$ et $\phi_d$ désignent respectivement l'amplitude et la phase du signal prédistordu, le signal radio d' est normalement de la forme $\rho_d$ cos($\omega$t+$\phi_d$), la fréquence f=$\omega$/2$\pi$ étant la fréquence nominale du canal de communication utilisé.

L'amplificateur de puissance 20 amplifie le signal radio d' et fournit le signal radio amplifié à l'antenne 22 de l'émetteur. Un coupleur 24 prélève une fraction r' du signal radio amplifié en sortie de l'amplificateur 20. Cette fraction r' est fournie à un démodulateur en quadrature 26 qui, à l'aide des ondes cos$\omega$t et -sin$\omega$t issues de l'oscillateur local, produit un signal complexe démodulé r. Les composantes en phase $I_r$ et en quadrature $Q_r$ du signal démodulé sont numérisées par un convertisseur analogique-numérique 28 à la fréquence d'échantillonnage $F_s$, sur le même nombre de bits que les composantes du signal d'entrée m (par exemple 12 bits).

La figure 2 montre un schéma synoptique de la source de signal numérique 10. La référence 30 désigne la source d'information binaire de l'émetteur, qui délivre des bits d'information $a_0,a_1,...$ codés et mis en forme selon les formats propres au système de radiocommunication adopté. Une unité logique 32 code les bits d'information pour produire des composantes codées en phase $I_i$ et en quadrature $Q_i$ à une cadence moitié de celle des bits d'information conformément au type de modulation utilisé. Cette modulation est à enveloppe non constante. Dans l'exemple considéré, il s'agit d'une modulation différentielle par déplacement de phase en quadrature avec des sauts de phase de $\pm\pi$/4 ou $\pm 3\pi$/4 (modulation $\pi$/4-DQPSK). Les composantes $I_i$ et $Q_i$ de l'échantillon i du signal complexe codé sont alors respectivement de la forme cos$\phi_i$ et sin$\phi_i$, le saut de phase $\phi_{i+1}$-$\phi_i$ dépendant des valeurs des deux bits d'information successifs $a_{2i}$, $a_{2i+1}$ de la manière indiquée dans le tableau I.

TABLEAU I

| $a_{2i}$ | $a_{2i+1}$ | $\phi_{i+1}$-$\phi_i$ |
|---|---|---|
| 0 | 0 | +$\pi$/4 |
| 0 | 1 | +3$\pi$/4 |
| 1 | 0 | -$\pi$/4 |
| 1 | 1 | -3$\pi$/4 |

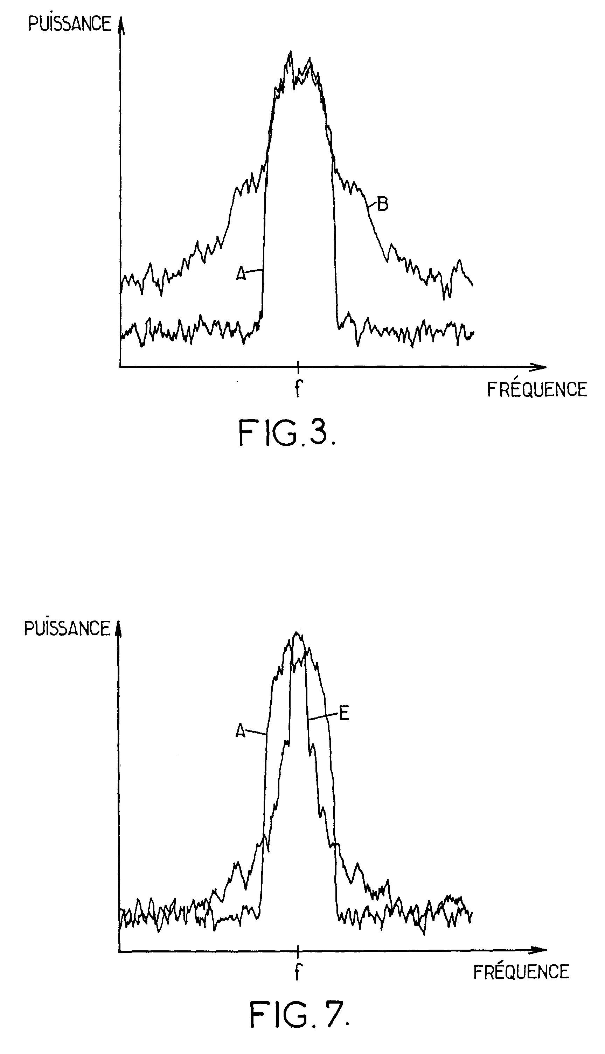

Pour limiter la largeur du spectre du signal, la fréquence d'échantillonnage $F_s$ est supérieure à la cadence des bits d'information. Par exemple, si les bits d'information $a_{2i}$, $a_{2i+1}$ ont une cadence de 36 kbit/s, les échantillons complexes $I_i$, $Q_i$ sont à une cadence de 18 kbit/s, et on peut les suréchantillonner dans un facteur 8 pour avoir une fréquence d'échantillonnage $F_s$ de 144 kHz. Les composantes $I_i$ et $Q_i$ sont chacune mises en forme par un filtre 34 de type demi-Nyquist adapté à la fréquence de suréchantillonnage $F_s$. Ceci produit le signal d'entrée en bande de base m ayant un spectre confiné dans une largeur de bande de 18 kHz. On peut alors prévoir dans le système de radiocommunication des canaux fréquentiels multiples espacés de 25 kHz par exemple, assurant une utilisation intensive de la bande passante disponible. Il convient toutefois de faire en sorte que la chaîne d'émission ne génère pas de composantes spectrales en dehors de la bande de 18 kHz pour ne pas perturber les canaux adjacents. A titre d'illustration, la figure 3 montre l'allure du spectre du signal radio $\pi$/4-DQPSK amplifié linéairement (courbe A) et amplifié avec un amplificateur non linéaire à fort rendement (courbe B). L'élargissement du spectre dû aux non-linéarités n'est pas acceptable. C'est la raison pour laquelle on prévoit l'unité de prédistorsion 12 dont le rôle est de compenser les non-linéarités de l'amplificateur de puissance 20.

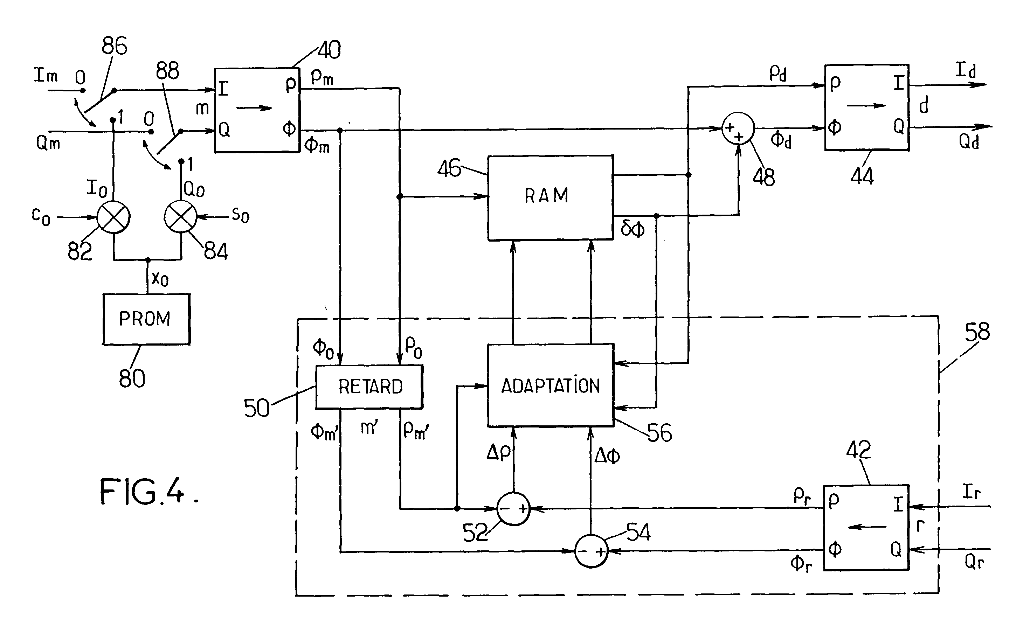

La figure 4 montre un exemple de réalisation de l'unité de prédistorsion 12. Les distorsions introduites par l'amplificateur 20 étant supposées être de type AM-AM et AM-PM, la prédistorsion est appliquée en coordonnées polaires $\rho$, $\phi$ et non en coordonnées cartésiennes I, Q. Trois unités arithmétiques 40, 42, 44 sont ainsi prévues pour respectivement convertir en coordonnées polaires $\rho_m$, $\phi_m$ le signal d'entrée m, convertir en coordonnées polaires $\rho_r$, $\phi_r$ le signal démodulé r, et convertir en coordonnées cartésiennes $I_d$, $Q_d$ le signal prédistordu d calculé en coordonnées polaires $\rho_d$, $\phi_d$. Le module $\rho_m$ du signal d'entrée sert de pointeur d'adresse dans une mémoire vive (RAM) 46 où est stockée une table de prédistorsion associant à chaque valeur quantifiée de $\rho_m$ une valeur du module $\rho_d$ du signal prédistordu, et une valeur de déphasage $\delta\phi$ à appliquer pour prédistordre le signal. En pratique, pour limiter la taille mémoire requise, l'adressage dans la mémoire 46 peut s'effectuer à l'aide de log$_2$K bits de poids fort de $\rho_m$, par exemple les 5 bits de poids les plus forts pour une table de prédistorsion à K=32 entrées, les valeurs mémorisées $\rho_d$, $\delta\phi$ pouvant être quantifiées sur 12 bits. Un sommateur 48 ajoute le déphasage $\delta\phi$ à la phase $\phi_m$ du signal d'entrée pour produire la phase $\phi_d$ du signal prédistordu.

Les valeurs contenues dans la table de prédistorsion sont calculées de manière adaptative. Durant une période d'adaptation, le signal complexe d'entrée m n'est pas celui délivré par les filtres 34, mais un signal d'adaptation particulier. Ces périodes d'adaptation sont dédiées à la linéarisation de l'amplificateur et non à la transmission d'un signal utile. A titre d'exemple, dans le cas d'un système à accès multiple par répartition dans le temps (TDMA) avec des intervalles de temps d'émission de 510 bits à 36 kbit/s, on peut prévoir des périodes d'adaptation initiale correspondant à des intervalles de temps de 238 bits (soit 952 échantillons complexes ou ~6,6 ms) dédiées à la convergence de l'algorithme de prédistorsion et, au début de chaque intervalle de temps d'émission, une période d'adaptation de 32 bits (soit 128 échantillons complexes ou ~0,89 ms) dédiée au rafraîchissement de la table de prédistorsion.

Le signal démodulé r recueilli pendant les périodes d'adaptation est comparé au signal d'adaptation pour mettre à jour la table de prédistorsion. Le signal d'adaptation exprimé en coordonnées polaires $\rho_0$, $\phi_0$ est retardé par un filtre 50 d'un temps préréglé pour compenser le retard que le signal r subit en traversant la chaîne radio. Le signal retardé m' peut ainsi être comparé, au moyen de soustracteurs 52, 54, au signal démodulé r qui lui correspond. Le soustracteur 52 produit la différence $\Delta\rho=\rho_r-\rho_{m'}$ entre les modules du signal démodulé et du signal d'adaptation retardé. Le soustracteur 54 produit la différence $\Delta\phi=\phi_r-\phi_{m'}$ entre les phases du signal démodulé et du signal d'adaptation retardé. Une unité d'adaptation 56 procède à la mise à jour de la table de prédistorsion. Si $k=q(\rho_{m'})$ désigne l'adresse dans la mémoire 46 correspondant à un échantillon du module $\rho_m$, du signal d'adaptation retardé ($k=q(\rho_{m'})$ est représenté par les 5 bits de poids fort de $\rho_{m'}$ dans l'exemple de quantification précédemment considéré où K=32), l'adaptation peut simplement consister à mettre à jour les valeurs $\rho_d^{(k)}$ et $\delta\phi^{(k)}$ stockées à l'adresse k selon :

$$\rho_d^{(k)} = \rho_d^{(k)} - c_\rho.\Delta p \tag{1}$$

$$\delta\phi^{(k)} = \delta\phi^{(k)} - c_\phi.\Delta\phi \tag{2}$$

où $c_\rho$ et $c_\phi$ sont des coefficients d'amortissement compris entre 0 et 1. Sur la figure 4, la référence 58 désigne les moyens numériques servant à la mise à jour de la table de prédistorsion, à savoir l'unité arithmétique 42, le filtre 50, les soustracteurs 52, 54 et l'unité d'adaptation 56.

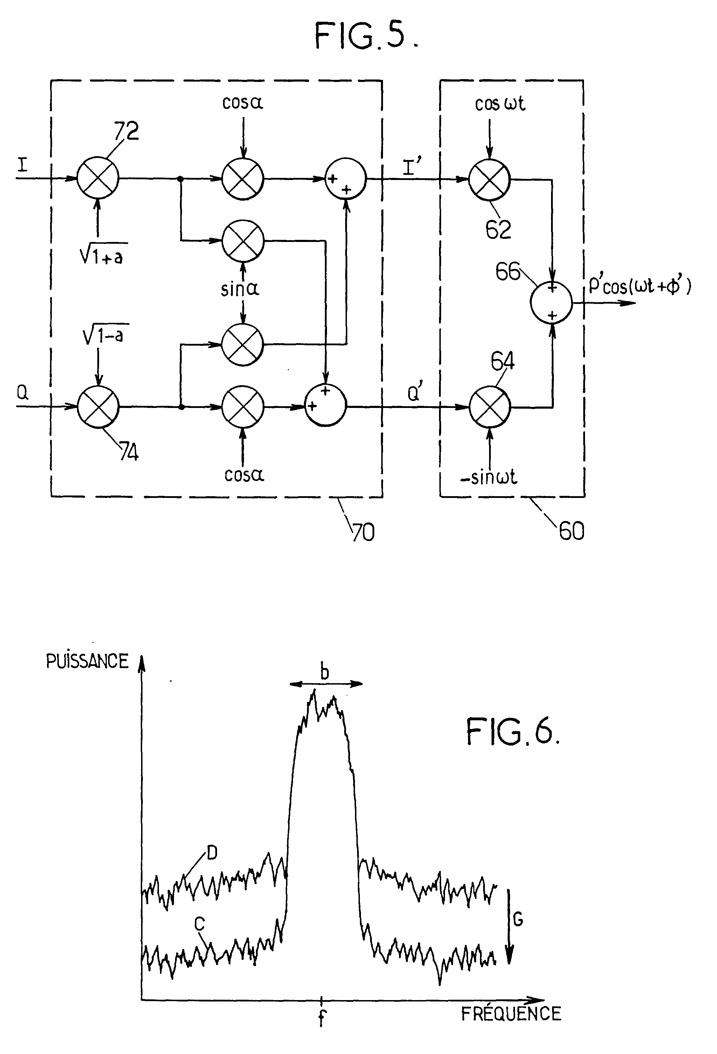

L'hypothèse selon laquelle les distorsions à compenser sont seulement de type AM-AM et AM-PM ne tient pas compte des défauts de balance et/ou de quadrature que peut présenter le modulateur 16 ou le démodulateur 26. La figure 5 est un schéma modélisant un modulateur présentant de tels défauts (une présentation semblable pourrait être faite pour le démodulateur). La référence 60 désigne un modulateur en quadrature idéal avec deux multiplieurs 62, 64 modulant respectivement l'onde cos$\omega$t par la composante en phase I' présente à l'entrée, et l'onde -sin$\omega$t par la composante en quadrature Q', et un sommateur 66 délivrant le signal modulé à partir des sorties des multiplieurs 62, 64 (bien entendu, la modulation peut également être effectuée en passant par une ou plusieurs fréquences intermédiaires). Dans le cas du modulateur idéal, le signal modulé est de la forme $\rho'\cos(\omega t+\phi')$ si $I'+jQ'=\rho'e^{j\phi'}$. Un défaut de balance se traduit par le fait que les composantes I et Q subissent des gains différents dans le modulateur, ce qui est représenté par les multiplieurs 72 et 74 appliquant respectivement les gains $\sqrt{1+a}$ et $\sqrt{1-a}$ aux composantes en phase et en quadrature ($a\neq0$ crée un défaut de balance). Un défaut de quadrature correspondrait au fait que les deux ondes issues de l'oscillateur local ne seraient pas exactement en quadrature. Dans le modèle de défauts 70 représenté sur la figure 5, un défaut de quadrature correspond à un angle $\alpha$ non nul, le signal d'entrée I, Q du modulateur réel étant déformé en $I'=I.\sqrt{1+a}.\cos\alpha+Q.\sqrt{1-a}.\sin\alpha$, $Q'=I.\sqrt{1+a}.\sin\alpha+Q.\sqrt{1-\alpha}.\cos\alpha$ à l'entrée d'un modulateur idéal 60. Avec ce modèle, le module $\rho'$ et la phase $\phi'$ du signal modulé vérifient les relations suivantes, en fonction du module $\rho$ et de la phase $\phi$ du signal complexe I, Q :

$$\left(\frac{\rho'}{\rho}\right)^2 = 1+a.cos2\phi+\sqrt{1-a^2}.sin2\phi.sin2\alpha \tag{3}$$

$$tg\phi' = \frac{\sqrt{1-a}.tg\phi + \sqrt{1+a}.tg\alpha}{\sqrt{1+a} + \sqrt{1-a}tg\phi tg\alpha} \tag{4}$$

Le module est déformé en fonction de la phase à l'entrée (distorsion PM-AM), et la phase à la sortie dépend de la phase à l'entrée de façon non-linéaire (distorsion PM-PM). Ceci contredit l'hypothèse de distorsion AM-AM et AM-PM sur laquelle se base la technique de prédistorsion. Les défauts de balance et de quadrature dégradent donc la performance de la linéarisation par prédistorsion.

En pratique, les défauts de balance et de quadrature sont relativement faibles (a et $\alpha$ petits), de sorte que les distorsions PM-AM et PM-PM ne provoquent qu'une petite perturbation du spectre. Si ces distorsions peuvent rester acceptables en ce qui concerne l'élargissement du spectre qu'elles provoquent directement en dehors des périodes d'adaptation, les inventeurs ont constaté qu'elles détérioraient les performances en provoquant en outre une convergence de la table de prédistorsion vers des valeurs inadéquates.

Ce dernier inconvénient peut être contourné en utilisant un signal complexe d'adaptation ayant une phase $\phi_0$ constante modulo $\pi$, c'est-à-dire des composantes en phase et en quadrature dans un rapport de proportionnalité constant ($=tg\phi_0$). D'après les relations (3) et (4), si $tg\phi$ est constante, la distorsion induite par les défauts de balance et de quadrature revient à multiplier le signal modulant par une constante complexe, ce qui ne perturbe pas le comportement de convergence de l'algorithme de prédistorsion.

En pratique, l'unité de prédistorsion 12 introduit une certaine fluctuation $\delta\phi$ dans la phase $\phi_d$ du signal prédistordu appliqué au modulateur 16 lorsque la phase $\phi_0$ du signal d'adaptation est constante. Néanmoins, cette fluctuation reste de faible amplitude étant donné qu'elle correspond approximativement aux distorsions de phase dues aux non-linéarités de l'amplificateur 20, lesquelles sont typiquement inférieures à 10°. En conséquence, cette fluctuation $\delta\phi$ ne perturbe pas trop la convergence, en tous cas beaucoup moins que si on laissait la phase $\phi_0$ varier avec une amplitude de l'ordre de $\pi$. La fluctuation de phase $\delta\phi$ est par ailleurs compensée par la non-linéarité de l'amplificateur 20 dans le signal d'entrée r' du démodulateur 26, de sorte que les distorsions PM-AM et PM-PM induites par le démodulateur restent approximativement constantes durant l'adaptation et ne perturbent pas la convergence.

A titre de comparaison, la figure 6 montre le spectre d'un signal radio amplifié obtenu (en dehors des périodes d'adaptation) en utilisant un signal d'adaptation à phase constante (courbe C) et un signal d'adaptation à phase variable de même nature que le signal d'entrée m généré en dehors des périodes d'adaptation (courbe D). Pour une puissance donnée dans la bande passante b, on observe, avec des défauts de balance et de quadrature typiques des modulateurs et démodulateurs couramment employés dans les terminaux mobiles de radiocommunication, une diminution G pouvant aller jusqu'à 10 dB voire davantage du niveau de bruit généré dans les canaux adjacents, grâce à la meilleure convergence de l'algorithme de prédistorsion.

Dans l'exemple représenté sur la figure 4, le signal d'adaptation à phase constante modulo $\pi$ est généré à l'aide d'une mémoire 80 de type PROM dans laquelle sont lus à la cadence $F_s$ les échantillons successifs d'une fonction $x_0(t)$. Deux multiplieurs 82, 84 multiplient la sortie $x_0$ de la mémoire 80 par des constantes $c_0$ et $s_0$ pour produire respectivement les composantes en phase $I_0$ et en quadrature $Q_0$ du signal d'adaptation. Deux commutateurs 86, 88 sont commandés par le contrôleur d'émission du terminal pour adresser à l'entrée de l'unité arithmétique 40 les composantes $I_m$, $Q_m$ issues de la source de signal numérique 10 en dehors des périodes d'adaptation (position 0), et les composantes $I_0$, $Q_0$ du signal d'adaptation pendant les périodes d'adaptation (position 1). La phase $\phi_0$ du signal d'adaptation est alors constante modulo $\pi$, avec $tg\phi_0=s_0/c_0$, le module $\rho_0$ du signal d'adaptation étant donné par $\rho_0^2=x_0^2 \cdot (s_0^2+c_0^2)$. Le choix $s_0=c_0=1$ ($\phi_0=\pi/4$ ou $5\pi/4$) est commode car il permet de se dispenser des multiplieurs 82, 84 ($I_0=Q_0=x_0$). Les valeurs de la fonction $x_0(t)$ stockées dans la mémoire 80 sont choisies de manière à présenter une distribution apte à explorer la gamme de dynamique souhaitée de l'amplificateur 20.

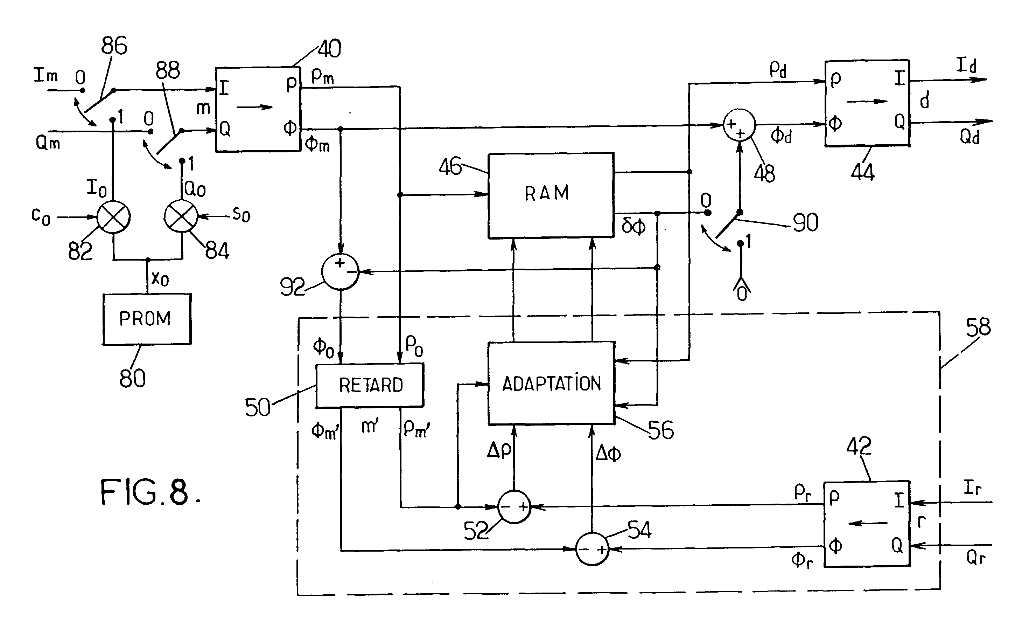

Il a par ailleurs été observé qu'il était judicieux de choisir le signal d'adaptation de façon qu'il ait un spectre sensiblement plus étroit que celui du signal d'entrée m généré en dehors des périodes d'adaptation. Ceci évite, lorsque l'algorithme de prédistorsion n'a pas encore convergé, de générer de la puissance indésirable en dehors de la bande passante, ce qui gênerait les canaux adjacents. Une façon de le faire consiste à réduire le débit de la source d'information binaire 30 pendant les périodes d'adaptation (le signal d'adaptation n'étant alors pas obtenu à partir de la mémoire 80 représentée sur la figure 4 mais en sortie des filtres 34). A titre d'illustration, la figure 7 montre (courbe E) le spectre d'un signal radio $\pi/4$-DQPSK amplifié non linéairement et obtenu à partir d'un signal d'adaptation généré en réduisant d'un facteur 4 le débit de la source d'information binaire 30 (9 kbit/s au lieu de 36 kbit/s). Cette courbe E est à comparer à la courbe B de la figure 3 qui serait son homologue dans le cas où le débit de la source d'information binaire serait maintenu inchangé dans les périodes d'adaptation. On constate que l'utilisation d'un signal d'adaptation à bande étroite conduit à une forte réduction de la puissance rayonnée en dehors du canal pendant les périodes d'adaptation.

Dans une version préférée de l'invention, le signal d'adaptation présente à la fois les propriétés de phase constante et de bande étroite dont les avantages ont été présentés ci-dessus. Une manière commode de réaliser ceci consiste à prévoir un signal d'adaptation dont les parties réelle et imaginaire soient proportionnelles à une même forme d'onde sinusoïdale de fréquence $f_0$ sensiblement inférieure au quart du débit de la source d'information binaire 30. Le spectre du signal d'adaptation se réduit alors à deux raies espacées de $2f_0$. Dans l'exemple représenté sur la figure 4, il suffit de stocker dans la mémoire 80 une fonction $x_0(t)$ proportionnelle à $\cos(2\pi f_0 t+\theta)$, $\theta$ étant une constante. Dans l'exemple précédemment évoqué d'un rythme binaire de 36 kbit/s en sortie de la source 30, on a obtenu des résultats satisfaisants en prenant $f_0=4,5$ kHz.

La variante de réalisation de l'unité de prédistorsion 12 représentée sur la figure 8 diffère de celle de la figure 4 en ce que la phase maintenue constante modulo $\pi$ est non pas celle du signal d'adaptation, mais celle du signal d'adaptation prédistordu. La phase étant alors constante (modulo $\pi$) à l'entrée du modulateur 16, la convergence de l'algorithme d'adaptation n'est pas perturbée par les défauts de balance et de quadrature du démodulateur (relations (1) et (2)), indépendamment des prédistorsions de phase $\delta\phi$ contenues dans la table de prédistorsion. En contrepartie, la distorsion AM-PM due aux non-linéarités de l'amplificateur 20 provoque une fluctuation de l'ordre de $\delta\phi$ (générale-ment faible) à l'entrée du démodulateur 26.

Les éléments constitutifs de l'unité de prédistorsion représentée sur la figure 8 sont pour la plupart identiques à ceux décrits en référence à la figure 4, et désignés par les mêmes références numériques. Un commutateur 90 est ajouté pour ne transmettre au sommateur 48 la prédistorsion de phase $\delta\phi$ lue dans la mémoire 46 qu'en dehors des périodes d'adaptation (position 0). Dans les périodes d'adaptation, la commutateur 90 adresse une valeur nulle au sommateur 48 (position 1), ce qui assure que la phase du signal prédistordu corresponde à la phase constante modula $\pi$ délivrée par l'unité arithmétique 40. Pour reconstituer le signal d'adaptation auquel est associé le signal prédistordu à phase constante, un soustracteur calcule la différence entre la phase $\phi_m$ délivrée par l'unité arithmétique 40 et la prédistorsion de phase $\delta\phi$ lue dans la mémoire 46. Cette différence représente la phase $\phi_0$ du signal d'adaptation, et est fournie aux moyens de mise à jour 58 pour qu'après le retard ad hoc, elle soit comparée à la phase $\phi_r$ du signal démodulé.

On note que dans le cas représenté sur la figure 8, on ne connaît pas a priori le signal d'adaptation dont la phase $\phi_0$ dépend des valeurs $\delta\phi$ stockée dans la table, ni le signal prédistordu dont le module $\rho_d$ est lu dans la table. En revanche, le module $\rho_0$ du signal d'adaptation et la phase $\phi_d$ ($tg\phi_d = s_0/c_0$) du signal prédistordu sont prédéfinis. En prenant la fonction $x_0(t)$ proportionnelle à $\cos(2\pi f_0 t + \theta)$ comme exposé précédemment, le signal d'adaptation et le signal prédistordu ont un spectre plus étroit dans la périodes d'adaptation qu'en dehors de ces périodes, ce qui assure une faible perturbation des canaux adjacents. Si $c_0 = s_0$, le signal prédistordu a des parties réelle et imaginaire identiques.

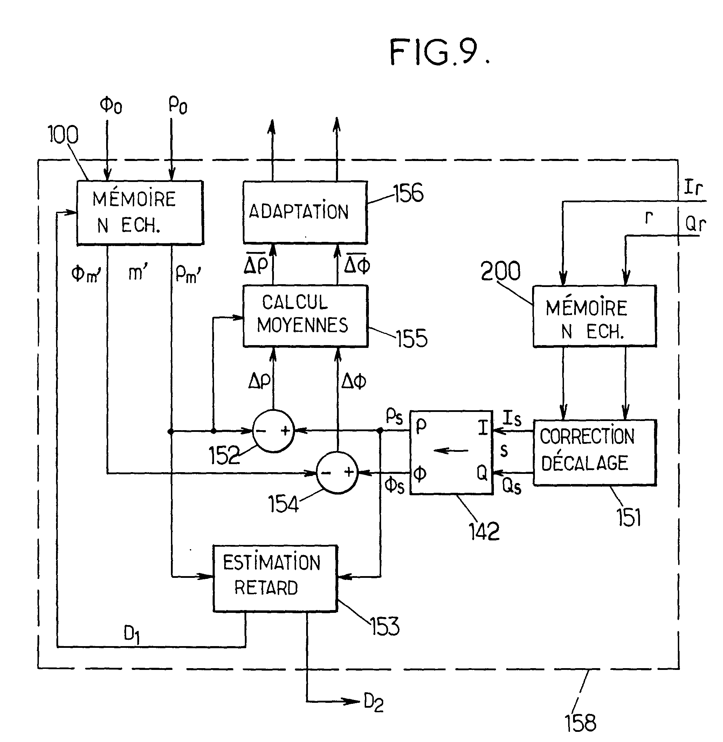

La figure 9 montre une variante de réalisation avantageuse 158 des moyens de mise à jour 58 d'une unité de prédistorsion selon la figure 4 ou la figure 8. Deux mémoires tampon 100, 200 sont prévues pour mémoriser N échantillons complexes successifs du signal d'adaptation et du signal démodulé dans les périodes d'adaptation. Le nombre N est typiquement choisi égal au nombre d'échantillons à la fréquence $F_s$ du signal d'adaptation dans la période d'adaptation. Dans l'exemple représenté, la mémoire 100 reçoit les coordonnées polaires $\rho_0$, $\phi_0$ du signal d'adaptation, tandis que la mémoire 200 reçoit les coordonnées cartésiennes $I_r$, $Q_r$ du signal démodulé r.

Les traitements de mise à jour de la table de prédistorsion sont effectués après la réception des deux blocs de N échantillons du signal d'adaptation et du signal démodulé. Le premier de ces traitements, opéré par l'unité 151, consiste en la correction d'un décalage de zéro que peut présenter le signal démodulé r. Le signal d'adaptation étant à moyenne nulle, il en est normalement de même du signal démodulé. Toutefois, des défauts du modulateur 16 et/ou du démodulateur 26 peuvent provoquer un décalage de zéro (offset) dans le signal démodulé. Pour éviter que ce décalage affecte l'algorithme de prédistorsion, l'unité 151 calcule les moyennes, sur le bloc de N échantillons, des composantes en phase et en quadrature du signal démodulé, et soustrait ces moyennes des échantillons mémorisés :

$$\bar{I} = \frac{1}{N} \sum_{i=1}^{N} I_r(i)$$

$$\bar{Q} = \frac{1}{N} \sum_{i=1}^{N} Q_r(i)$$

et, pour i=1,...,N : $I_s(i) = I_r(i) - \bar{I}$, et $Q_s(i) = Q_r(i) - \bar{Q}$. Dans les expressions ci-dessus, $I_r(i)$ et $Q_r(i)$ désignent les i-ièmes échantillons mémorisés des composantes en phase et en quadrature du signal complexe démodulé r, et $I_s(i)$ et $Q_s(i)$ désignent les i-ièmes échantillons des composantes en phase et en quadrature d'un signal démodulé corrigé s que l'unité de correction 151 fournit à l'unité arithmétique 142. L'unité 142 produit le module $\rho_s$ et la phase $\phi_s$ du signal démodulé corrigé s.

Un autre traitement, effectué par une unité 153, consiste en l'estimation du retard du signal démodulé r par rapport au signal d'adaptation qui lui correspond. Cette estimation comprend le calcul d'une corrélation $\Delta D$ selon :

$$\Delta D = \frac{1}{L} \sum_{i=1}^{L} \rho_s(i) \cdot [\rho_{m'}(i-1) - \rho_{m'}(i+1) + \rho_s(i+1) - \rho_s(i-1)]$$

puis une mise à jour du retard D appliqué au signal d'adaptation selon :

$$D = D + c_d . \Delta D / F_s$$

Dans les expressions ci-dessus, $c_d$ désigne un coefficient d'amortissement compris entre 0 et 1, L désigne une longueur de bloc pour l'estimation du retard ($L \leq N$, typiquement $L \sim 100$), $\rho_s(i)$ désigne le i-ième échantillon du module du signal démodulé corrigé, et $\rho_{m'}(i)$ désigne le i-ième échantillon du module du signal d'adaptation retardé. Une fois que l'estimation du retard D fournit une valeur stable, cette valeur est figée afin d'éviter les calculs assurés par l'unité 153. Le retard estimé D étant de la forme $D = D_1/F_s + D_2$ avec $0 \leq D_2 < 1/F_s$ et $D_1$ entier, une possibilité commode pour appliquer ce retard consiste à fournir le retard entier $D_1$ à la mémoire 100 pour décaler de $D_1$ adresses la lecture des échantillons $P_m'$, $\phi_{m'}$ dans cette mémoire, et à utiliser le retard fractionnaire $D_2$ pour décaler l'horloge du convertisseur analogique-numérique 28.

Les moyens de mise à jour 158 représentés sur la figure 9 comprennent deux soustracteurs 152, 154 calculant les différences respectives entre les modules et les phases du signal démodulé corrigé s et du signal d'adaptation retardé m': $\Delta\rho(i) = \rho_s(i) - \rho_{m'}(i)$ et $\Delta\phi(i) = \phi_s(i) - \phi_{m'}(i)$. Ces différences $\Delta\rho(i)$, $\Delta\phi(i)$ sont fournies à une unité 155 de calcul de valeurs moyennes. Pour chaque index k de quantification des modules $\rho_m$ à l'entrée de la mémoire 46, l'unité 155 calcule les moyennes $\overline{\Delta\rho}^{(k)}$ et $\overline{\Delta\phi}^{(k)}$ des écarts $\Delta\rho(i)$ et $\Delta\phi(i)$ délivrés par les soustracteurs 152, 154 pour lesquels le module $\rho_{m'}$ du signal d'adaptation est quantifié par l'index k:

$$\overline{\Delta\phi}^{(k)} = \frac{\displaystyle\sum_{\substack{i=1 \\ q(\rho_{m'}(i))=k}}^{N} \Delta\phi(i)}{\displaystyle\sum_{\substack{i=1 \\ q(\rho_{m'}(i))=k}}^{N} 1}$$

$$\overline{\Delta\rho}^{(k)} = \frac{\displaystyle\sum_{\substack{i=1 \\ q(\rho_{m'}(i))=k}}^{N} \Delta\rho(i)}{\displaystyle\sum_{\substack{i=1 \\ q(\rho_{m'}(i))=k}}^{N} 1}$$

L'unité d'adaptation 156 met ensuite à jour les valeurs $\rho_d^{(k)}$ et $\delta\phi^{(k)}$ stockées à chaque adresse k ($1 \leq k \leq K$) dans la mémoire 46 selon :

$$\rho_d^{(k)} = \rho_d^{(k)} - c_\rho \cdot \overline{\Delta\rho}^{(k)} \tag{5}$$

$$\delta\phi^{(k)} = \delta\phi^{(k)} - c_\phi \cdot \overline{\Delta\phi}^{(k)} \tag{6}$$

Les valeurs stockées aux K adresses de la table de prédistorsion sont ainsi mises à jour à la fin du traitement d'un bloc de N échantillons. La prise en compte de valeurs moyennes $\overline{\Delta\rho}^{(k)}$ et $\overline{\Delta\phi}^{(k)}$ dans les relations (5) et (6) permet, par rapport à l'utilisation des relations (1) et (2) sans moyennage, de réduire les erreurs dues aux défauts du modulateur et/ou du démodulateur (balance ou quadrature) et aux interférences inter-échantillons, et de réduire également l'influence du bruit présent dans le signal démodulé. Le moyennage permet également à l'algorithme de prédistorsion de converger plus vite. Le traitement par blocs a en outre pour avantages de mesurer et d'éliminer le décalage de zéro du signal démodulé (unité 151), et de permettre une estimation fine du retard D à appliquer au signal d'adaptation.

**Revendications**

1. Procédé pour corriger des non-linéarités d'un amplificateur (20) recevant un signal radio (d') et produisant un signal radio amplifié représentatif d'un signal numérique complexe d'entrée (m), dans lequel on mémorise une table de prédistorsion associant une valeur d'un signal numérique complexe prédistordu à chaque valeur du signal numérique complexe d'entrée, et on module le signal complexe prédistordu (d) pour obtenir le signal radio adressé à l'amplificateur, le procédé comportant au moins une période d'adaptation dans laquelle on démodule une fraction (r') du signal radio amplifié pour obtenir un signal complexe démodulé (r) qu'on compare au signal complexe d'entrée auquel est associé le signal complexe prédistordu modulé dans ladite période d'adaptation pour mettre à jour la table de prédistorsion, **caractérisé en ce que** la table de prédistorsion est mise à jour sur la base de valeurs moyennes calculées à partir de blocs d'échantillons du signal complexe d'entrée et du signal complexe démodulé mémorisés dans la période d'adaptation.

2. Procédé selon la revendication 1, **caractérisé en ce que** le module du signal complexe d'entrée est quantifié pour l'adressage dans la table de prédistorsion, la table de prédistorsion associant une valeur de module ($\rho_d$) et une valeur de déphasage ($\delta\phi$) du signal prédistordu à chaque valeur de quantification du module du signal complexe d'entrée, et **en ce que**, pour chaque valeur de quantification (k) du module du signal complexe d'entrée, on calcule la valeur moyenne ($\overline{\Delta\rho}^{(k)}$) de la différence de module entre le signal complexe démodulé et le signal complexe d'entrée, et la valeur moyenne ($\overline{\Delta\phi}^{(k)}$) de la différence de phase entre le signal complexe démodulé et le signal complexe d'entrée, lesdites valeurs moyennes étant calculées pour les échantillons du signal complexe d'entrée du bloc mémorisé dans la période d'adaptation dont le module est quantifié par ladite valeur de quantification, et on met à jour la valeur de module ($\rho_d^{(k)}$) et la valeur de déphasage ($\delta\phi^{(k)}$) du signal complexe prédistordu associées à ladite valeur de quantification sur la base desdites valeurs moyennes calculées.

3. Procédé selon la revendication 1 ou 2, **caractérisé en ce que** chaque bloc d'échantillons du signal complexe démodulé est mémorisé sous forme de composantes en phase ($I_r(i)$) et de composantes en quadrature ($Q_r(i)$), **en ce qu'**on estime la valeur moyenne ($\overline{I}$) des composantes en phase du bloc et la valeur moyenne ($\overline{Q}$) des composantes en quadrature du bloc, et **en ce qu'**on produit un signal complexe démodulé corrigé (s) pour la mise à jour de la table de prédistorsion en soustrayant respectivement des composantes en phase et en quadrature mémorisées de chaque échantillon du signal complexe démodulé les valeurs moyennes estimées desdites composantes en phase et en quadrature.

4. Procédé selon l'une quelconque des revendications 1 à 3, **caractérisé en ce qu'**on calcule une corrélation ($\Delta D$) entre le module du signal complexe démodulé et le module du signal complexe d'entrée, et **en ce que**, pour mettre à jour la table de prédistorsion, on compare le signal complexe démodulé au signal complexe d'entrée retardé d'un temps réglé en tenant compte de la corrélation calculée.

5. Procédé selon l'une quelconque des revendications 1 à 4, **caractérisé en ce que** le signal complexe d'entrée ou le signal complexe prédistordu possède une phase constante modulo $\pi$ dans la période d'adaptation.

6. Procédé selon l'une quelconque des revendications 1 à 5, **caractérisé en ce que** le signal complexe d'entrée a un spectre plus étroit dans la période d'adaptation qu'en dehors de la période d'adaptation.

7. Procédé selon l'une quelconque des revendications 1 à 6, **caractérisé en ce que**, dans la période d'adaptation, le signal complexe d'entrée a des parties réelle et imaginaire proportionnelles à une même forme d'onde sinusoïdale.

8. Procédé selon l'une quelconque des revendications 1 à 7, **caractérisé en ce que**, dans la période d'adaptation, le signal complexe d'entrée ou le signal complexe prédistordu a des parties réelle et imaginaire identiques.

**9.** Emetteur radio, comprenant : une source de signal numérique (10) générant un signal numérique complexe d'entrée (m) ; des moyens de prédistorsion (12) comportant une table de prédistorsion associant une valeur d'un signal numérique complexe prédistordu à chaque valeur du signal numérique complexe d'entrée ; des moyens de modulation (16) produisant un signal radio (d') à partir du signal complexe prédistordu (d) ; un amplificateur de puissance (20) pour amplifier le signal radio et l'appliquer à une antenne d'émission (22) ; et des moyens de démodulation (26) produisant un signal complexe démodulé (r) à partir d'une fraction (r') du signal radio amplifié, dans lequel les moyens de prédistorsion (12) sont agencés pour mettre à jour la table de prédistorsion sur la base d'une comparaison entre le signal complexe démodulé produit par les moyens de démodulation dans au moins une période d'adaptation et le signal complexe d'entrée auquel est associé le signal complexe prédistordu produit dans ladite période d'adaptation par les moyens de prédistorsion, **caractérisé en ce que** les moyens de prédistorsion (12) sont agencés pour mettre à jour la table de prédistorsion sur la base de valeurs moyennes calculées à partir de blocs d'échantillons du signal complexe d'entrée et du signal complexe démodulé mémorisés dans la période d'adaptation.

## Patentansprüche

**1.** Verfahren zur Korrektur von nichtlinearen Verzerrungen in einem Verstärker (20), der ein Funksignal (d') empfängt und ein verstärktes Funksignal erzeugt, das repräsentativ für ein komplexes digitales Eingangssignal (m) ist, wobei eine Vorverzerrungstabelle gespeichert wird, die einem jeden Wert des komplexen digitalen Eingangssignals einen Wert eines vorverzerrten komplexen Digitalsignals zuordnet, und das vorverzerrte komplexe Signal (d) moduliert wird, um das an den Verstärker adressierte Funksignal zu erhalten, wobei das Verfahren mindestens eine Anpassungsperiode aufweist, in welcher ein Teil (r') des verstärkten Funksignals demoduliert wird, um ein demoduliertes komplexes Signal (r) zu erhalten, das mit dem komplexen Eingangssignal verglichen wird, dem das modulierte vorverzerrte komplexe Signal in der Anpassungsperiode zugeordnet wird, um die Vorverzerrungstabelle zu aktualisieren, **dadurch gekennzeichnet, daß** die Vorverzerrungstabelle auf der Grundlage von ausgehend von Abtastblöcken des komplexen Eingangssignals und des demodulierten komplexen Signals berechneten Mittelwerten aktualisiert wird, die in der Anpassungsperiode gespeichert werden.

**2.** Verfahren nach Anspruch 1, **dadurch gekennzeichnet, daß** das Modul des komplexen Eingangssignals für die Adressierung in der Vorverzerrungstabelle quantifiziert wird, wobei die Vorverzerrungstabelle einen Modulwert ($\rho_d$) und einen Phasendifferenzwert ($\delta\phi$) des vorverzerrten Signals zu jedem Quantifizierungswert des Moduls des komplexen Eingangssignals zuordnet, und daß für jeden Quantifizierungswert (k) des Moduls des komplexen Eingangssignals der Mittelwert ($\overline{\Delta\rho}^{(K)}$) der Moduldifferenz zwischen dem demodulierten komplexen Signal und dem komplexen Eingangssignal und der Mittelwert ($\overline{\Delta\phi}^{(k)}$) der Phasendifferenz zwischen dem demodulierten komplexen Signal und dem komplexen Eingangssignals berechnet wird, wobei diese Mittelwerte für die Abtastproben des komplexen Eingangssignals des in der Anpassungsperiode gespeicherten Blocks berechnet werden, dessen Modul durch den Quantifizierungswert quantifiziert ist, und der Modulwert ($\rho_d^{(k)}$) und der Phasendifferenzwert ($\delta\phi^{(k)}$) des vorverzerrten komplexen Signals, die diesem Quantifizierungswert zugeordnet sind, auf der Grundlage der berechneten Mittelwerte aktualisiert werden.

**3.** Verfahren nach Anspruch 1 oder 2, **dadurch gekennzeichnet, daß** jeder Block von Abtastproben des demodulierten komplexen Signals in Form von phasengleichen Komponenten ($I_r(i)$) und von 90° phasenverschobenen Komponenten ($Q_r(i)$) gespeichert wird, daß der Mitelwert ($\overline{I}$) der phasengleichen Komponenten des Blocks und der Mittelwert ($\overline{Q}$) der 90° phasenverschobenen Komponenten des Blocks geschätzt werden, und daß ein korrigiertes demoduliertes komplexes Signal (s) für die Aktualisierung der Vorverzerrungstabelle erzeugt wird, indem jeweils von den gespeicherten phasengleichen Komponenten und 90° phasenverschobenen Komponenten einer jeden Abtastprobe des demodulierten komplexen Signals die geschätzten Mittelwerte der phasengleichen Komponenten bzw. der 90° phasenverschobenen Komponenten subtrahiert werden.

**4.** Verfahren nach einem der Ansprüche 1 bis 3, **dadurch gekennzeichnet, daß** eine Korrelation ($\Delta D$) zwischen dem Modul des demodulierten komplexen Signals und dem Modul des komplexen Eingangssignals berechnet wird, und daß zur Aktualisierung der Vorverzerrungstabelle das demodulierte komplexe Signal mit dem komplexen Eingangssignal verglichen wird, das um eine unter Berücksichtigung der berechneten Korrelation regulierte Zeit verzögert ist.

**5.** Verfahren nach einem der Ansprüche 1 bis 4, **dadurch gekennzeichnet, daß** das komplexe Eingangssignal oder das vorverzerrte komplexe Signal in der Anpassungsperiode eine konstante Phase Modulo $\pi$ besitzt.

**6.** Verfahren nach einem der Ansprüche 1 bis 5, **dadurch gekennzeichnet, daß** das komplexe Eingangssignal in der Anpassungsperiode ein engeres Spektrum als außerhalb der Anpassungsperiode aufweist.

**7.** Verfahren nach einem der Ansprüche 1 bis 6, **dadurch gekennzeichnet, daß** das komplexe Eingangssignal in der Anpassungsperiode einen realen Teil und einen imaginären Teil aufweist, die zu einer gleichen Sinuswellenform proportional sind.

**8.** Verfahren nach einem der Ansprüche 1 bis 7, **dadurch gekennzeichnet, daß** das komplexe Eingangssignal oder das vorverzerrte komplexe Signal in der Anpassungsperiode einen realen Teil und einen imaginären Teil aufweist, die identisch sind.

**9.** Funksender, welcher aufweist: eine Digitalsignalquelle (10), welche ein komplexes digitales Eingangssignal (m) erzeugt; eine Vorverzerrungseinrichtung (12) mit einer Vorverzerrungstabelle, welche einem jeden Wert des komplexen digitalen Eingangssignals einen Wert eines vorverzerrten komplexen Digitalsignals zuordnet; eine Modulationseinrichtung (16) zum Erzeugen eines Funksignals (d') ausgehend von dem vorverzerrten komplexen Signal (d); einen Leistungsverstärker (20) zum Verstärken und Anlegen des Funksignals an eine Sendeantenne (22); und eine Demoduliereinrichtung (26), welche ein demoduliertes komplexes Signal (r) ausgehend von einem Teil (r') des verstärkten Funksignals erzeugt, wobei die Vorverzerrungseinrichtung (12) dazu konzipiert ist, die Vorverzerrungstabelle auf der Grundlage eines Vergleichs zwischen dem von der Demodulationseinrichtung in mindestens einer Anpassungsperiode erzeugten demodulierten komplexen Signal und dem komplexen Eingangssignal, dem das in der Anpassungsperiode von der Vorverzerrungseinrichtung erzeugte vorverzerrte komplexe Signal zugeordnet ist, zu aktualisieren, **dadurch gekennzeichnet, daß** die Vorverzerrungseinrichtung (12) dazu konzipiert ist, die Vorverzerrungstabelle auf der Grundlage von Mittelwerten zu aktualisieren, die ausgehend von Blöcken von Abtastproben des komplexen Eingangssignals und des demodulierten komplexen Signals berechnet sind, die in der Anpassungsperiode gespeichert wurden.

## Claims

**1.** Method of correcting nonlinearities of an amplifier (20) which receives a radio signal (d') and produces an amplified radio signal representing an input complex digital signal (m), wherein a predistortion table, associating a value of a predistorted complex digital signal with each value of the input complex digital signal, is stored, and the predistorted complex signal (d) is modulated in order to obtain the radio signal addressed to the amplifier, the method including at least one adaptation period in which a fraction (r') of the amplified radio signal is demodulated in order to obtain a demodulated complex signal (r) which is compared with the input complex signal, with which the predistorted complex signal modulated in said adaptation period is associated, in order to update the predistortion table, **characterized in that** the predistortion table is updated on the basis of mean values calculated from blocks of samples of the input complex signal and of the demodulated complex signal, which are stored in the adaptation period.

**2.** Method according to Claim 1, **characterized in that** the modulus of the input complex signal is quantized for addressing in the predistortion table, the predistortion table associating a modulus value ($\rho_d$) and a phase-shift value ($\delta\phi$) for the predistorted signal with each quantizing value of the modulus of the input complex signal, and **in that**, for each quantizing value (k) of the modulus of the input complex signal, the mean value ($\overline{\Delta\rho}^{(k)}$) of the difference in modulus between the demodulated complex signal and the input complex signal, and the mean value ($\overline{\Delta\phi}^{(k)}$) of the phase difference between the demodulated complex signal and the input complex signal, are calculated, said mean values being calculated for the samples of the input complex signal in the block stored in the adaptation period, whose modulus is quantized by said quantizing value, and the modulus value ($\rho_d^{(k)}$) and the phase-shift value ($\delta\phi^{(k)}$) of the predistorted complex signal, which are associated with said quantizing value, are updated on the basis of said calculated mean values.

**3.** Method according to Claim 1 or 2, **characterized in that** each block of samples of the demodulated complex signal is stored in the form of in-phase components ($I_r(i)$) and quadrature components ($Q_r(i)$), **in that** the mean value ($\overline{I}$) of the in-phase components of the block and the mean value ($\overline{Q}$) of the quadrature components of the block are estimated, and **in that** a corrected demodulated complex signal (s) is produced in order to update the predistortion table by respectively subtracting, from the stored in-phase and quadrature components of each sample of the demodulated complex signal, the estimated mean values of said in-phase and quadrature components.

4. Method according to any one of Claims 1 to 3, **characterized in that** a correlation ($\Delta$D) between the modulus of the demodulated complex signal and the modulus of the input complex signal is calculated, and **in that**, in order to update the predistortion table, the demodulated complex signal is compared with the input complex signal, delayed by a time which is adjusted with reference to the calculated correlation.

5. Method according to any one of Claims 1 to 4, **characterized in that** the input complex signal or the predistorted complex signal has a phase which is constant modulo $\pi$ in the adaptation period.

6. Method according to any one of Claims 1 to 5, **characterized in that** the input complex signal has a narrower spectrum within the adaptation period than outside the adaptation period.

7. Method according to any one of Claims 1 to 6, **characterized in that**, in the adaptation period, the input complex signal has real and imaginary parts proportional to a common sinusoidal waveform.

8. Method according to any one of Claims 1 to 7, **characterized in that**, in the adaptation period, the input complex signal or the predistorted complex signal has identical real and imaginary parts.

9. Radio transmitter, comprising: a digital signal source (10) generating an input complex digital signal (m); predistortion means (12) including a predistortion table associating a value of a predistorted complex digital signal with each value of the input complex digital signal; modulation means (16) producing a radio signal (d') from the predistorted complex signal (d); a power amplifier (20) for amplifying the radio signal and applying it to a transmission antenna (22); and demodulation means (26) producing a demodulated complex signal (r) from a fraction (r') of the amplified radio signal, wherein the predistortion means (12) are designed to update the predistortion table on the basis of a comparison between the demodulated complex signal, produced by the demodulation means in at least one adaptation period, and the input complex signal, with which the predistorted complex signal produced in said adaptation period by the predistortion means is associated, **characterized in that** the predistortion means (12) are designed to update the predistortion table on the basis of mean values calculated from blocks of samples of the input complex signal and of the demodulated complex signal which are stored in the adaptation period.

## FIG.1.

## FIG.2.

FIG.3.

FIG.7.

FIG.4.

# FIG.5.

# FIG.6.

FIG.8.

# FIG.9.